# EUROPÄISCHE PATENTSCHRIFT

(11) **EP 2 629 339 B1**
(45) Veröffentlichungstag und Bekanntmachung des Hinweises auf die Patenterteilung: **15.04.2015**
(21) Anmeldenummer: 12156060.1
(22) Anmeldetag: 17.02.2012
(51) Int. Cl.: H01L 31/05

(54) **Foliensystem zur Kontaktierung von Photovoltaik-Zellen**
Film system for contacting photovoltaic cells
Système de feuille pour la mise en contact de cellules photovoltaïques

(43) Veröffentlichungstag der Anmeldung: 21.08.2013
(73) Patentinhaber: Eppstein Technologies GmbH, 65817 Eppstein (DE)
(72) Erfinder: Waegli, Peter, 5620 Bremgarten (CH)
(74) Vertreter: Meyer-Dulheuer, Karl-Hermann

(56) Entgegenhaltungen:
- US-A1- 2007 283 997
- US-B1- 6 184 457

## Beschreibung

Die vorliegende Erfindung betrifft ein Foliensystem zur Kontaktierung von Photovoltaik(PV)-Zellen mit mindestens einer Metallfolie und mindestens einer Isolationsschicht, wobei die Isolationsschicht auf die Metallfolie aufgebracht ist, sowie mindestens zwei Photovoltaik-Zellen. Ebenso ist ein Verfahren zur Herstellung des erfindungsgemäßen Foliensystems Gegenstand der Erfindung. Ein solches Foliensystem ist in dem Dokument US-A-2007/0283997 offenbart. Ein PV-Modul wandelt Sonnenlicht direkt in elektrische Energie um und enthält als wichtigsten Bestandteil mehrere PV-Zellen (bis zu 60 Zellen), die miteinander verschaltet sind. Die Zellen werden hierfür mittels unterschiedlicher Materialien verpackt und zu einem Verbund zusammengefasst, der mehrere Zwecke erfüllt: Der Verbund bildet eine transparente, strahlungs- und witterungsbeständige Abdeckung und liefert durch die entsprechende Verpackung robuste elektrische Anschlüsse. Die spröden PV-Zellen und elektrischen Verbindungen werden sowohl vor mechanischen Einflüssen als auch vor Feuchtigkeit geschützt. Die elektrischen Bauteile werden vor Zugriffen geschützt und die Module können besser gehandhabt und befestigt werden. Es gibt verschiedenste Bauformen von PV-Modulen mit unterschiedlichen Arten von PV-Zellen.

In der Regel besitzen PV-Module eine Glasplatte auf der zur Sonne gewandten Seite (Frontseite), wobei meist ein sogenanntes Einscheiben-Sicherheits-Glas (ESG) verwendet wird. Über eine transparente Kunststoffschicht, wie beispielsweise Ethylenvinylacetat (EVA) oder Silikongummi, ist diese in der Regel mit den Zellen verbunden. In diese Kunststoffschicht sind die PV-Zellen eingebettet, die durch Lötbändchen elektrisch miteinander verschaltet sind. Auf der Rückseite werden die Module mit einer witterungsfesten Kunststoffverbundfolie, beispielsweise aus Polyvinylfluorid oder Polyester, oder einer weiteren Glasscheibe, abgeschlossen. Bei der Fertigung von PV-Modulen werden diese in der Regel bei etwa 150°C laminiert. Beim Laminieren bildet sich aus der bis dahin milchigen EVA-Folie eine klare, dreidimensional vernetzte und nicht mehr aufschmelzbare Kunststoffschicht, in der die PV-Zellen eingebettet sind und die fest mit der Glasscheibe und der Rückseitenfolie verbunden ist.

Mono- und mehrkristalline PV-Zellen werden aus sogenannten Wafern (einkristalline oder mehrkristalline Siliziumscheiben) hergestellt, wie sie in gleicher oder ähnlicher Form auch für die Halbleiterherstellung verwendet werden. Diese Siliziumzellen weisen großtechnisch einen Wirkungsgrad von bis zu 20 % oder mehr und eine Leistungsdichte von 20 - 50 W/kg auf. Mehrere dieser Zellen werden in einem PV-Modul mittels Lötbändchen zu einzelnen Strängen (sogenannte Strings) in Serie geschaltet, bis die richtige Ausgangsspannung erreicht ist. Mehrere solcher Zellgruppen werden daraufhin entweder wieder seriell oder parallel geschaltet, wobei im ersten Fall die Spannungen und im zweiten Fall die Ausgangsströme addiert und zu den Modulanschlüssen geführt werden. Die dazu verwendeten Leitungen werden als Busbars bezeichnet. Für die Verstringung der Zellen müssen jeweils die Kontakte auf der Vorderseite einer Zelle (z.B. Minuspol) mit den Kontakten auf der Rückseite der nächsten Zelle (Pluspol) verbunden werden, wozu häufig verzinnte Kupferbändchen eingesetzt werden die typischerweise bis zu 200 µm dick sind. In der Regel sind diese Kontakte als ca. 2 mm breite metallisierte Linien ausgebildet, welche sich über die ganze Länge der Zelle hinziehen, sogenannte Kontaktlinien. Es können pro Pol zwei oder auch drei solcher Kontaktlinien vorgesehen sein. PV-Zellen mit dieser Art der Anschlussanordnung werden auch als sogenannte H-Zellen bezeichnet.

Da die Bändchen wegen der Abschattung auf der Vorderseite der Zelle nicht beliebig breit sein können können, müssen sie eine gewisse Dicke aufweisen, damit der elektrische Widerstand der Verbindung nicht zu hoch wird, typischerweise bis zu 200 µm. Die Erhöhung der Dicke der Bändchen hat jedoch gewisse Nachteile. Zum einen ist der Zellenabstand durch den Platz mitbestimmt, der durch das Umbiegen der Bändchen von der Front auf die Rückseite benötigt wird. Dadurch kann der Zellenabstand von typischerweise 3 mm nicht unterschritten werden. Die Zellen liegen zudem auf den relativ dicken und schmalen Bändchen auf, was den mechanischen Stress in den Zellen im Laminationsprozess erhöht. Bei immer dünner werdenden Zellen kann dies zu vermehrten Zellbrüchen und damit zu Modulausfällen in einem späten Stadium der Modulherstellung führen. Bei den heute üblichen Verfahren werden zudem zunächst die Zellen mittels der Bändchen miteinander zu einem String verbunden, der dann in das Modul transferiert wird. Dieser Prozess ist aufwendig und fehleranfällig.

Die Aufgabe der vorliegenden Erfindung war es daher, eine Möglichkeit zu schaffen, eine Verschaltung von Photovoltaik-Waferzellen zu PV-Modulen zu schaffen, die die Nachteile aus dem Stand der Technik überwindet.

Gelöst wird die Aufgabe durch das erfindungsgemäße Foliensystem zur Kontaktierung von Photovoltaik-Zellen, umfassend eine Metallfolie, eine Isolationsschicht, wobei die Isolationsschicht auf die Metallfolie aufgebracht ist, und mindestens zwei Photovoltaik-Zellen. Eine erste Photovoltaik-Zelle kommt dabei auf der Isolationsschicht zu liegen, wobei die Isolationsschicht unterhalb einer Photovoltaik-Zelle Öffnungen (Kontaktierungsöffnungen) aufweist, um eine elektrische Verbindung der Metallfolie, die sich unterhalb der Isolationsschicht befindet, zu der mindestens einen Kontaktlinie auf der Unterseite der ersten Photovoltaik-Zelle zu gewährleisten, welche auf der Isolationsschicht liegt. Die Kontaktierungsöffnungen befinden sich dabei unter einer Kontaktlinie der Zellenunterseite. Die Metallfolie weist dabei mindestens einen Anschlussfinger auf, wobei der mindestens eine Anschlussfinger der Metallfolie, welche sich unterhalb der ersten Photovoltaik-Zelle befindet, auf der mindestens einen Kontaktlinie auf der Vorderseite einer zweiten Photovoltaik-Zelle zu liegen kommt, und die Isolationsschicht, auf welcher die erste Photovoltaik-Zelle liegt, sich oberhalb des mindestens einen Anschlussfingers der benachbarten zweiten Photovoltaik-Zelle befindet. Es ist dabei bevorzugt, dass auf der Unterseite und der Oberseite einer PV-Zelle die gleiche Anzahl an Kontaktlinien vorhanden ist.

Bei dem erfindungsgemäßen Foliensystem zur Kontaktierung von Photovoltaik-Zellen kommt demnach eine Metallfolie zum Einsatz, auf deren Oberseite eine Isolierungsschicht aufgebracht ist. Jede PV-Zelle eines mit dem erfindungsgemäßen Foliensystem hergestellten PV-Moduls kommt mit der Unterseite auf der Isolierungsschicht zu liegen, unter welcher sich die Metallschicht befindet, und auf der Vorderseite (Oberseite) liegen die Anschlussfinger auf. In dem Bereich, der jeweils auf der Vorderseite einer PV-Zelle zu liegen kommt, wird mittels Laser- oder Ätzverfahren die Metallschicht abgetragen, so dass nur noch die Anschlussfinger übrig bleiben. Da die Anschlussfinger aus der Metallschicht bestehen, befindet sich demnach oberhalb der Anschlussfinger die Isolierungschicht.

Im Sinne dieser Erfindung sind unter Anschlussfinger die nach der Laser- oder Ätzbearbeitung übrigbleibenden Metallstreifen zu verstehen, welche über die metallisierten Linien (Kontaktlinien) auf der Zellen-Vorderseite zu liegen kommen und diese kontaktieren. Diese Linien stellen den Kontakt auf der Vorderseite der PV-Zelle dar und ziehen sich über die ganze Länge der Zelle hin. Es können pro Pol zwei oder mehrere solcher Kontaktlinien vorgesehen sein: Dabei liegen die Kontaktlinien auf der Vorderseite einer Zelle in der Fortsetzung der Kontaktlinien auf der Rückseite der Nachbarzelle.

Durch die Kombination von flächigem Leiter auf der Rückseite der PV-Zellen und Bändchengeometrie durch die Anschlussfinger auf der Vorderseite der PV-Zellen kann insgesamt die Leiterdicke reduziert werden, ohne den ohmschen Verlust ansteigen zu lassen. Damit können dünnere Einbettmaterialien verwendet werden, was hilft, die Kosten zu reduzieren. Zudem liegt die Zelle auf einem flächigen Leiter auf und nicht auf Bändchen, wodurch der mechanische Stress auf die Zelle reduziert wird.

Eine Folie, bestehend aus Metallfolie und Isolationsschicht, kontaktiert demnach jeweils die Unterseite einer PV-Zelle und die Vorderseite einer benachbarten PV-Zelle. Unter der PV-Zelle, auf deren Vorderseite die erste Folie zu liegen kommt, kommt eine zweite Folie, ebenfalls bestehend aus Metallfolie und Isolationsschicht, zu liegen. Auf diese Weise können eine ganze Reihe von PV-Zellen hintereinander geschaltet werden.

In einer Ausführungsform wird die Metallfolie in dem Bereich, welcher auf einer Vorderseite einer PV-Zelle zu liegen kommt, mittels Laserverfahren oder einem Ätzprozess so abgetragen, dass mindestens ein Anschlussfinger entsteht. Die Kunststofffläche der transparenten Isolationsschicht bleibt dabei intakt.

Es ist dabei bevorzugt, dass die Metallfolie zwei oder mehrere leitende Anschlussfinger zum Anschluss an die Zellenvorderseite aufweist, je nachdem wie viele Kontaktlinien die Zelle aufweist.

Die Metallfolie besteht vorzugsweise aus Kupfer oder Aluminium. Es ist ebenfalls möglich, hierfür Zinn oder eine Zinnlegierung, oder eine plattierte Zinnfolie oder Silberfolie einzusetzen. In einer weiteren vorteilhaften Ausgestaltung weist die Metallfolie eine Dicke von mindestens 25 µm auf, vorzugsweise 25 µm bis 250 µm, besonders bevorzugt 50 µm bis 100 µm auf.

Weiterhin ist es bevorzugt, dass die Metallfolie im Falle von Aluminium mit einer Beschichtung versehen ist, vorzugsweise aus reinem oder legiertem Kupfer oder Nickellegierungen, welche gut mittels Lot und/oder Leitkleber und/oder Bonding zu kontaktieren ist. Bei der Nickellegierung handelt es sich bevorzugt um eine Chrom-Nickellegierung. Diese Beschichtung erfolgt bevorzugt im Bereich der Kontaktöffnungen, um die Kontaktierung des vorzugsweise verwendeten Aluminiums zu erlauben bzw. zu verbessern.

Werden PV-Zellen vom n-Typ für ein PV-Modul verwendet, welche einen wesentlich höheren Wirkungsgrad aufweisen, ist keine durchgängige metallisierte Rückseite in der PV-Zelle vorhanden. Um Strahlung, welche beim ersten Durchgang nicht absorbiert wurde, beispielsweise bei der Verwendung dünner Zellen, trotzdem wieder zu verwenden, muss ein zusätzlicher Reflektor angebracht werden. In einer weiteren vorteilhaften Ausgestaltung der vorliegenden Erfindung ist die Metallfolie mit einer Schicht versehen, die die Reflexion erhöht. Vorzugsweise handelt es sich hierbei um eine mit einer Silberoberfläche beschichte Zinnfolie oder mit Siliziumdioxid und/oder Titandioxid beschichtetes Aluminium. Diese Schicht ermöglicht eine besonders effiziente Reflexion des Lichts, das durch die aktive Schicht dringt. Diese Schicht sollte eine Reflexion von > 80 % im Wellenlängenbereich von 300 nm bis 1000 nm aufweisen.

In einer weiteren vorteilhaften Ausgestaltung ist die Metallfolie mit einer Oberflächentextur versehen. Diese stellt sicher, dass das Licht so zurückreflektiert wird, dass ein möglichst effektives "Light Trapping" in den Zellen erzielt wird. Die Oberflächentextur besteht vorzugsweise aus dreidimensionalen, regelmäßigen oder unregelmäßigen Strukturen. Besonders bevorzugt besteht die Oberflächentextur der Metallfolie aus Pyramiden oder Halbkugeln. Hierbei ist es von Vorteil, wenn die Oberflächentextur und/oder die Pyramiden oder Halbkugeln eine Höhe von 1-20 µm, vorzugsweise 5-15 µm, besonders bevorzugt 5-10 µm aufweist. Es ist weiterhin von Vorteil, wenn die Oberflächentextur und/oder die Pyramiden oder Halbkugeln eine zufällige Höhenverteilung von 1-20 µm, vorzugsweise 5-15 µm, besonders bevorzugt 5-10 µm aufweisen. In einer weiteren vorteilhaften Ausführungsform besteht die Oberflächentextur aus Pyramiden der bevorzugten Größe mit einem Scheitelwinkel von < 160°, vorzugsweise < 140°.

In einer weiteren alternativen Ausgestaltung besteht die Oberflächentextur der Metallfolie aus Pyramiden oder Halbkugeln, die eine charakteristische Größe von höchstens 1000 nm aufweisen. Es ist weiterhin bevorzugt, wenn die Oberflächentextur und/oder die Pyramiden oder Halbkugeln eine zufällige Höhenverteilung von 10-1000 nm, vorzugsweise 100-1000 nm aufweisen.

Weiterhin ist es bevorzugt, dass jede PV-Zelle auf ihrer Unterseite mindestens eine Kontaktlinie aufweist und auf ihrer Vorderseite ebenfalls mindestens eine Kontaktlinie aufweist. Diese Linien stellen den Kontakt auf der Vorderseite der PV-Zelle dar und ziehen sich über die ganze Länge der Zelle hin. Es können pro Pol zwei oder mehrere solcher Kontaktlinien vorgesehen sein. Dabei liegen die Kontaktlinien auf der Vorderseite einer Zelle in der Fortsetzung der Kontaktlinien auf der Rückseite der Nachbarzelle.

Eine Isolationsschicht wird haftend auf die Metallfolie aufgebracht und isoliert die Zelle elektrisch von der Metallfolie. In dem Bereich der Folie, bestehend aus Metallfolie und Isolationsschicht, welche jeweils die Unterseite der PV-Zellen kontaktiert, wird die Isolationsschicht selektiv entfernt, so dass einzelne Kontaktöffnungen entstehen, damit elektrische Kontakte zwischen der Metallschicht innerhalb des Verbundsystems und der PV-Zellen hergestellt werden können. Dies kann durch mechanische oder chemische Abtragung oder eine Abtragung mittels Laser geschehen. Die Isolationsschicht ist außerdem entweder selbst haftend oder mit einem Verbindungsmittel versehen. Dies erleichtert das Fixieren von Zellen auf dem Folienverbund.

Als Isolationsschicht wird bevorzugt Kunststoff oder ein Kunstharz eingesetzt. Bei dem Kunstharz handelt es sich vorzugsweise um ein Epoxid-Harz. In einer Ausführungsform des erfindungsgemäßen Folienverbundes besteht die Isolationsschicht bevorzugt aus Copolymeren, beispielsweise Ethylenvinylacetat (EVA), silikonbasierte Kunststoffen, beispielsweise Tectosil (Wacker) und/oder thermoplastischen Kunststoffen, beispielsweise lonomere. Diese Materialien haben den Vorteil, dass gleichzeitig eine Haftung erreicht wird, so dass sich die einzelnen Komponenten während des Laminationsprozesses nicht verschieben. Die Isolationsschicht ist dabei vorzugsweise im sichtbaren sowie auch im nahen IR-Bereich optisch transparent, um die Laserbearbeitung der Metallschicht durch die Isolationsschicht zu erlauben. Zudem weisen sie haftende Eigenschaften auf, bzw. entwickeln bei erhöhter Temperatur solche Eigenschaften. Bei einem weiteren geeigneten Kunststoff, der haftende Eigenschaften aufweist und für die Isolationsschicht verwendet wird, handelt es sich vorzugsweise um Polyvinylbutyral (PVB).

Die Isolationsschicht soll vorzugsweise im Bereich von 400 nm bis 1100 nm optisch transparent sein (Absorptionskoeffizient α<3*10⁻³/cm). Das Licht, welches durch die aktive Schicht dringt, wird zur Metallfolie durchgelassen, so dass es von dieser zurück in die aktive Schicht reflektiert wird.

Mittels unterschiedlicher Verbindungstechniken kann das Verbundsystem mit den PV-Zellen stabil verbunden werden. In einer vorteilhaften Ausgestaltungsform des erfindungsgemäßen Verbundsystems wird dieses mit Hilfe eines elektrisch leitenden Klebers mit den Zellen verbunden. In einer alternativen Ausgestaltung wird diese Verbindung mechanisch durch Verpressen oder durch Laserbearbeitung hergestellt.

Alternativ ist es ebenfalls möglich, dass während der Lamination gleichzeitig elektrische Verbindungen durch Löten hergestellt werden, vorzugsweise mittels tiefschmelzendem Lot.

In einer weiteren Ausgestaltungsform ist die Isolationsschicht mit einem Verbindungsmittel, vorzugsweise einem Kleber, versehen. Im Bereich der Kontaktinseln kann die Verbindung zwischen der Metallschicht und der Leiterstruktur, welche die Zellen verbindet mittels unterschiedlicher Verbindungstechniken hergestellt werden. In einer vorteilhaften Ausgestaltungsform des erfindungsgemäßen Verbundsystems wird dieses mit Hilfe eines elektrisch leitenden Klebers verbunden, der während des Laminationsprozesses ausgehärtet wird. In einer alternativen Ausgestaltung wird diese Verbindung mechanisch durch Verpressen während der Lamination oder durch Laserbearbeitung hergestellt. Alternativ ist es ebenfalls möglich, dass während der Lamination gleichzeitig elektrische Verbindungen durch Löten hergestellt werden, vorzugsweise mittels tiefschmelzendem Lot.

Dabei ist es bevorzugt, dass eine Folie, bestehend aus Metallfolie und Isolationsschicht, so abgemessen ist, dass eine PV-Zelle mit der Unterseite auf der Isolationsschicht liegt und die Anschlussfinger der Metallschicht genau eine zweite PV-Zelle auf deren Vorderseite abdecken.

In einer weiteren Ausführungsform kann die Folie, bestehend aus Metallfolie und Isolationsschicht, so abgemessen sein, dass sie in ihrer Breite mehrere PV-Zellen in einer Folge nebeneinander aufnehmen kann. Das Foliensystem für eine ganze Folge von Zellen umfasst die Metallfolie und Isolationsschicht für bis zu sechs nebeneinander liegende Zellen mit den dafür notwendigen Leiterbahnstrukturen und Anschlussgeometrien- Kontaktöffnungen (flächiger Leiter) für die Zellenunterseite und Anschlussfinger für die Zellenvorderseite der Nachbarreihe. So können beispielsweise bis zu zehn solche, in Längsrichtung übereinander angeordnete Reihen zu je sechs Zellen ein PV- Modul ergeben. Dabei werden bis zu sechs PV-Zellen nebeneinander auf der Isolationsschicht auf dem Bereich der Folie fixiert, welche mit Kontaktöffnungen versehen ist. Die Metallschicht in dem Bereich der Folie ohne Kontaktöffnungen, die auf die Vorderseite einer Zelle zu liegen kommt, ist so abgetragen worden, dass pro PV-Zelle mindestens ein Anschlussfinger vorhanden ist. Die zweite Folge von Zellen wird wie in dem Fall zugefügt, dass nur eine Reihe von Zellen vorhanden ist. Der Bereich der Folie, bestehend aus Metallfolie und Isolationsschicht, der mit den Anschlussfingern versehen ist, wird nach oben geklappt. Eine zweite Folie, die ebenfalls wie die erste in dem Bereich mit den Kontaktöffnungen mit PV-Zellen versehen ist, kommt so neben der ersten Folie zu liegen, dass die Anschlussfinger der ersten Folie genau auf der Vorderseite der PV-Zellen zu liegen kommen, welche den Bereich mit den Kontaktierungsöffnungen der zweiten Folie bedecken. Selbstverständlich sind bei dem erfindungsgemäßen Foliensystem für eine ganze Folge von Zellen auch andere Modulgrößen mit unterschiedlichen Zellenanzahlen mit umfasst. So sind neben dem bevorzugten Ausführungsbeispiel von sechs Zellen in zehn Reihen genauso zehn Zellen in sechs Reihen oder andere bevorzugte Zellen- und Reihenanzahlen möglich.

Weitere Vorteile ergeben sich aus einem Verfahren zur Herstellung eines Foliensystems zur Kontaktierung von Photovoltaik-Zellen. Eine Metallfolie wird hergestellt und im Falle von Aluminium mit einer Beschichtung versehen, welche vorzugsweise aus reinem oder legiertem Kupfer oder Nickellegierungen besteht. Bei der Nickellegierung handelt es sich bevorzugt um eine Chrom-Nickellegierung. Diese Beschichtung soll mittels Lot und/oder Leitkleber und/oder Bonding die Kontaktierung des vorzugsweise verwendeten Aluminiums der Metallfolie erlauben bzw. verbessern.

Anschließend wird die Metallfolie mit einer Isolationsschicht durch eine haftende Verbindung zusammengefügt. Dazu ist die Isolationsschicht entweder selbst haftend oder es wird ein Verbindungsmittel, vorzugsweise ein Kleber, eingesetzt. Alternativ ist es möglich, die Isolationsschicht mittels direkter Extrusion auf die Metallschicht aufzubringen. Während oder nach dem Verbinden der Metallfolie und der Isolationsschicht wird die Metallfolie beispielsweise mittels eines Laserprozesses, durch die transparente Isolationsschicht hindurch oder von der Metallseite her, lokal, selektiv abgetragen, so dass die Anschlussfinger entstehen. Dafür kommt vorzugsweise ein Laser mit einer Wellenlänge im nahen Infrarot, wie ein Faserlaser oder ein NdYag-Laser zur Anwendung. Anschließend wird die Isolationsschicht im Bereich des flächigen Leiters ebenfalls an bestimmten Stellen selektiv entfernt. Diese Kontaktierungsöffnungen stellen die elektrische Verbindung zu den Kontakten auf der Rückseite der Zelle her. Dafür wird idealerweise ein IR-Laser, beispielsweise ein CO₂-Laser, angewendet.

Bevorzugt wird das erfindungsgemäße Verfahren über einen "Roll-to-Roll" Prozess durchgeführt. Dazu wird die Isolationsschicht mittels Extrusion auf die Metallschicht aufgebracht. Dieser Verbund beider Schichten wird zunächst auf eine Rolle gewickelt und anschließend wieder abgewickelt. Mittels eines ersten Laserprozesses werden (in Transportrichtung) die Anschlussfinger aus der Metallschicht geschnitten. In einem zweiten Laserprozess, beispielsweise mit einem CO₂-Laser, wird die transparente Isolationsschicht selektiv an den Kontaktöffnungen zu der Metallfolie geöffnet. Anschließend wird das Foliensystem in formatübliche Größen geschnitten und für den Zusammenbau der PV-Module verwendet.

Alternativ kann zur Herstellung der Anschlussfinger bevorzugt ein Ätzprozess verwendet werden.

Auf die so hergestellte und vorbereitete Folie wird jeweils eine PV-Zelle mit einem elektrischen Verbindungsmittel auf den Bereich der Isolationsschicht der Folie aufgebracht, in welchem die Kontaktöffnungen zu der Metallfolie vorhanden sind. Mittels Wärmebehandlung wird die PV-Zelle auf der Isolationsschicht fixiert. Der Bereich der Folie mit dem mindestens einen Anschlussfinger, auf dem sich keine PV-Zelle befindet, wird nach oben geklappt, so dass eine weitere Folie mit einer PV-Zelle, welche auf den Bereich der Folie mit den Kontaktierungsöffnungen fixiert ist, an diese Stelle platziert werden kann. Auf diese Art und Weise können mehrere Folien, auf denen jeweils eine PV-Zelle im Bereich der Isolationsschicht mit den Kontaktöffnungen zu der Metallfolie fixiert sind und der Bereich der Folie mit dem mindestens einen Anschlussfinger nach oben geklappt ist, nebeneinander zu liegen kommen um eine ganze Reihe von PV-Zellen miteinander zu verschalten. Anschließend wird jeweils der nach oben geklappte, nicht von der Photovoltaik-Zelle besetzte Bereich der Folie, bestehend aus Isolationsschicht und Metallfolie, auf eine benachbarte Photovoltaik-Zelle runtergeklappt, so dass der mindestens eine Anschlussfinger die Vorderseite jeder PV-Zelle kontaktiert.

Somit ist jede Photovoltaik-Zelle elektrisch und mechanisch auf ihrer unteren Seite mit einer Isolationsschicht und der darunter liegenden Metallfolie sowie auf ihrer Vorderseite mit mindestens einem Anschlussfinger derselben Metallfolie und der darüber liegenden Isolationsschicht verbunden.

Weiterhin ist es Gegenstand der erfindungsgemäßen Verfahren, dass ein Verbindungsmittel auf die Kontaktflächen einer Photovoltaik-Zelle aufgetragen wird, das die elektrische Verbindung mit der Metallfolie herstellt. Vorzugsweise handelt es sich bei dem Verbindungsmittel um einen thermisch aushärtenden, elektrisch leitenden Kleber oder tiefschmelzendes Lot, so dass die elektrischen Verbindungen zu den PV-Zellen während des Laminierungsprozesses hergestellt werden können. Alternativ kann die elektrische Verbindung zwischen dem Verbundsystem und den PV-Zellen über einen Laserlötprozess erfolgen. In diesem Falle ist allerdings ein zusätzlicher Arbeitsgang zur Verarbeitung notwendig. Eine weitere Alternative der elektrischen Verbindung ist das mechanische Verpressen des Verbundsystems mit den Kontaktierungsöffnungen.

In einer weiteren vorteilhaften Ausgestaltung wird eine Reflektortextur in die Metallfolie geprägt. Vorzugsweise wird die Reflektortextur von einer geprägten Isolationsschicht bei dem Verbinden auf die Metallfolie übertragen. Diese Textur stellt sicher, dass das Licht so zurückreflektiert wird, dass möglichst viel Licht in die PV-Zelle zurückgeführt und dort absorbiert wird ("Light Trapping"). Die Metallschicht kann in einer weiteren alternativen Ausgestaltungsform perforiert sein, so dass eine bessere Haftung zu den benachbarten Schichten hergestellt werden kann.

Als Isolationsschicht wird bevorzugt Kunststoff oder ein Kunstharz eingesetzt. Bei dem Kunstharz handelt es sich vorzugsweise um ein Epoxid-Harz. Vorzugsweise handelt es sich bei dem geeigneten Kunststoff, der haftende Eigenschaften aufweist und für die Isolationsschicht verwendet wird, um PVB. In einer Ausführungsform können bevorzugt Copolymere, beispielsweise Ethylenvinylacetat (EVA), silikonbasierte Kunststoffe, beispielsweise Tectosil (Wacker) und/oder thermoplastische Kunststoffe, beispielsweise lonomere, als Material für die Isolationsschicht eingesetzt werden. Diese Materialien haben den Vorteil, dass gleichzeitig eine Haftung erreicht wird, so dass sich die einzelnen Komponenten während des Laminationsprozesses nicht verschieben. Das Epoxid-Harz kann mittels Temperatur und/oder UV-Strahlung ausgehärtet werden. Die Isolationsschicht ist dabei vorzugsweise im sichtbaren sowie nahen IR-Bereich optisch transparent, um die nicht-absorbierte Sonnenstrahlung durchzulassen und die Laserbearbeitung der Metallschicht durch die Isolationsschicht zu erlauben.

Die Isolationsschicht soll vorzugsweise im Bereich von 300 nm bis 1100 nm optisch transparent sein (α<3*10⁻³/cm). An den Kontaktierungsstellen zwischen der Metallfolie im Verbundsystem und den PV-Zellen-Kontakten auf der Rückseite weist die Isolationsschicht Unterbrechungen auf.

In einer weiteren vorteilhaften Ausgestaltung des erfindungsgemäßen Verfahrens wird die Metallfolie in Transportrichtung während des Verbindens beschnitten. Vorzugsweise kann dies mittels eines Laserverfahrens erfolgen. Somit kann das Verbundsystem bereits in der gewünschten Form und Größe produziert werden.

Das somit hergestellte Verbundsystem kann in einem Prozess, beispielsweise Lamination oder Verpressen mit den verschalteten PV-Zellen verbunden werden.

In einer alternativen Ausgestaltungsform des erfindungsgemäßen Verfahrens werden während des Laminationsvorgangs in einem Verfahrensschritt zusätzlich elektrische Verbindungen zwischen dem Verbundsystem und den PV-Zellen hergestellt, vorzugsweise mittels Löten besonders bevorzugt unter Verwendung von tiefschmelzendem Lot; das Modul nach hinten verschlossen; ein Deckglas aufgebracht und/oder die Einbettung der PV-Zellen bewerkstelligt. Zusätzlich wird über die Trägerfolie ein Anschluss nach außen hergestellt und das Modul wird so abgeschlossen, dass es vor Umwelteinflüssen geschützt ist.

In einer alternativen Ausgestaltungsform des erfindungsgemäßen Verfahrens werden während des Laminationsvorgangs in einem Verfahrensschritt zusätzlich elektrische Verbindungen zwischen dem Verbundsystem und den PV-Zellen hergestellt, vorzugsweise mittels Löten besonders bevorzugt unter Verwendung von tiefschmelzendem Lot; das Modul nach hinten verschlossen; ein Deckglas aufgebracht und die Einbettung der PV-Zellen bewerkstelligt.

Weiterhin ist es Gegenstand des erfindungsgemäßen Verfahrens, dass die mit dem Foliensystem, bestehend aus Isolationsschicht und Metallfolie, zur Kontaktierung vorbereiteten Photovoltaik-Zellen auf die Modulrückseite, bestehend aus rückseitigem Modulabschluss und Einbettfolie, gelegt werden, wobei die Anschlussfinger auf die zur Kontaktierung vorbereitete Vorderfläche der jeweiligen Nachbarzelle gelegt und vorzugsweise mittels Wärmebehandlung fixiert werden. Vorzugsweise wird das Modul mit einer Einbettschicht und einem Frontglas versehen. Weiterhin werden mittels Laminationsprozess die Schichten miteinander verbunden.

Das Foliensystem ermöglicht so die Modulverkapselung und Kontaktierung im Laminationsprozess, was die Modulmontage vereinfacht und die Anzahl Prozessschritte reduziert.

Weiterhin ist Gegenstand des erfindungsgemäßen Verfahrens, dass die Folie, bestehend aus Metallfolie und Isolationsschicht, so abzumessen ist, dass sie in ihrer Breite mehrere PV-Zellen nebeneinander aufnehmen kann. Das Foliensystem für eine ganze Folge von Zellen umfasst die Metallfolie und Isolationsschicht für bis zu sechs in Folge nebeneinander liegende Zellen mit den dafür notwendigen Leiterbahnstrukturen und Anschlussgeometrien, Kontaktöffnungen für die Zellenunterseite und Anschlussfinger für die Zellenvorderseite der Nachbarreihe. Vorzugsweise ergeben jeweils bis zu zehn solche in Längsrichtung übereinander angeordnete Reihen zu je sechs Zellen ein PV- Modul. Jeweils sechs Zellen, welche an den Kontaktierungsflächen mit einem Kontaktierungsmittel, vorzugsweise Leitkleber oder Lot-Paste, versehen sind, werden nebeneinander auf die Kontaktierungsflächen des Foliensystems aufgesetzt und mit einer Wärmebehandlung fixiert. Die Isolationsschicht ist an den jeweiligen Kontaktpunkten geöffnet und für die Kontaktierung vorbereitet. Die Metallschicht in dem Bereich der Folie ohne Kontaktinseln ist so abgetragen worden, dass pro PV-Zelle mindestens ein Anschlussfinger vorhanden ist. Selbstverständlich sind bei dem erfindungsgemäßen Verfahren auch die Herstellung anderer Modulgrößen mit unterschiedlichen Zellenanzahlen mit umfasst. So sind neben dem bevorzugten Ausführungsbeispiel von sechs Zellen in zehn Reihen genauso zehn Zellen in sechs Reihen oder andere bevorzugte Zellen- und Reihenanzahlen möglich.

Die so mit den Foliensystemen zur Kontaktierung vorbereitete Zellenreihe wird auf die Modulrückseite, bestehend aus rückseitigem Modulabschluss und Einbettfolie, aufgelegt, wobei die "Anschlussfinger" auf die zur Kontaktierung vorbereitete Vorderflächen der jeweiligen Nachbarzellenreihe gelegt werden. Die Anschlussfinger können ebenfalls mittels Wärmebehandlung fixiert werden.

Die zweite Folge von Zellen wird wie in dem Fall zugefügt, dass nur eine Reihe von Zellen vorhanden ist. Der Bereich der Folie, bestehend aus Metallfolie und Isolationsschicht, der mit den Anschlussfingern versehen ist, wird nach oben geklappt. Eine zweite Folie, die ebenfalls wie die erste in dem Bereich mit den Kontaktöffnungen mit PV-Zellen versehen ist, kommt so neben der ersten Folie zu liegen, dass die Anschlussfinger der ersten Folie genau auf der Vorderseite der PV-Zellen zu liegen kommen, welche den Bereich mit den Kontaktierungsöffnungen der zweiten Folie bedecken.

Sind alle zehn Reihen aufgelegt, wie oben beschrieben, so wird das Modul mit der Einbettschicht, dem Frontglas und den Anschlüssen nach Außen versehen und im Laminator mittels Verkapselung und Kontaktierung fertiggestellt.

Gegenstand der Erfindung ist zudem die Verwendung des erfindungsgemäßen Foliensystems zur Kontaktierung von Photovoltaik-Zellen, welche die Zellenanschlüsse auf der Vorder- und Rückseite (sogenannte H-Zellen) haben.

Mit dem erfindungsgemäßen Foliensystem zur Kontaktierung von Photovoltaik-Zellen können PV-Zellen eingesetzt werden, welche die Zellenanschlüsse auf der Vorder- und Rückseite (sogenannte H-Zellen) haben. Die Kombination von Kunststoff- und Metallfolien gewährleistet zum einen die Funktion einer elektrischen Serienschaltung einzelner Photovoltaik-Zellen in einem Modul (sogenannte Verstringung der Zellen). Zum anderen wird durch die Ausgestaltung der Metallfolie die Rückreflexion nicht absorbierter Strahlung in die Zellen zur Wiederverwertung gewährleistet. Bei den heute üblich eingesetzten PV-Zellen vom p-Typ ist die Zellen-Rückseite komplett metallisiert, was ausgenutzt wird, um die nicht bereits beim ersten Durchgang in der Zelle absorbierte Strahlung in die Zelle zurück zu reflektieren, so dass sie bei weiteren Durchgängen absorbiert werden kann. Bei den heute noch seltener eingesetzten PV-Zellen vom n-Typ, welche einen wesentlich höheren Wirkungsgrad aufweisen, ist diese metallisierte Rückseite nicht mehr durchgängig vorhanden. Um Strahlung, welche beim ersten Durchgang nicht absorbiert wurde, trotzdem wieder zu verwenden, muss ein zusätzlicher Reflektor angebracht werden. Die Metallschicht in dem erfindungsgemäßen Foliensystems kann in diesem Fall als Reflektor fungieren, wodurch nicht genutzte Sonnenstrahlen wieder auf die aktive Schicht reflektiert werden. Dadurch kann der Wirkungsgrad bei der Verwendung von beispielsweise n-Typ-Zellen verbessert werden. Desweiteren wird die mechanische und elektrische Verbindung der Zellen mit dem Foliensystem sowie die mechanische Verbindung mit dem Frontglas und der Modulrückseite im Laminationsprozess gewährleistet. Weiter wird auch die elektrische Verbindung zu den Außenanschlüssen des Moduls integriert.

Das vorgeschlagene Produkt ermöglicht somit die einfache und kostengünstige Produktion von Photovoltaikmodulen und eine Verbesserung von deren Effizienz und Zuverlässigkeit. Ebenso wird durch die Verwendung des erfindungsgemäßen Foliensystems und die daraus resultierende Einbettung der PV-Zellen und somit Vermeidung des mechanischen Stresses auch die Verwendung dünnerer Waferzellen ermöglicht, was eine substantielle Kostenreduktion nach sich zieht, da der Großteil der Modulkosten derzeit auf die Zellen entfällt.

Die vorliegende Erfindung wird anhand folgender Figuren näher erläutert. Es zeigen:
Fig. 1 eine schematische Darstellung der Modulmontage in drei Schritten;
Fig. 2 eine perspektivische Darstellung des erfindungsgemäßen Foliensystems zur Verschaltung von zwei Zellen;
Fig. 3 eine schematische Darstellung des erfindungsgemäßen Foliensystems zur Verschaltung von zwei Zellen, gesehen durch die Isolationsschicht;
Fig. 4 eine schematische Darstellung des erfindungsgemäßen Foliensystems zur Kontaktierung einer ganzen Zellenreihe, versehen mit flächigem Anschluss für die Zellenunterseiten und Anschlussfingern für die Zellenvorderseiten

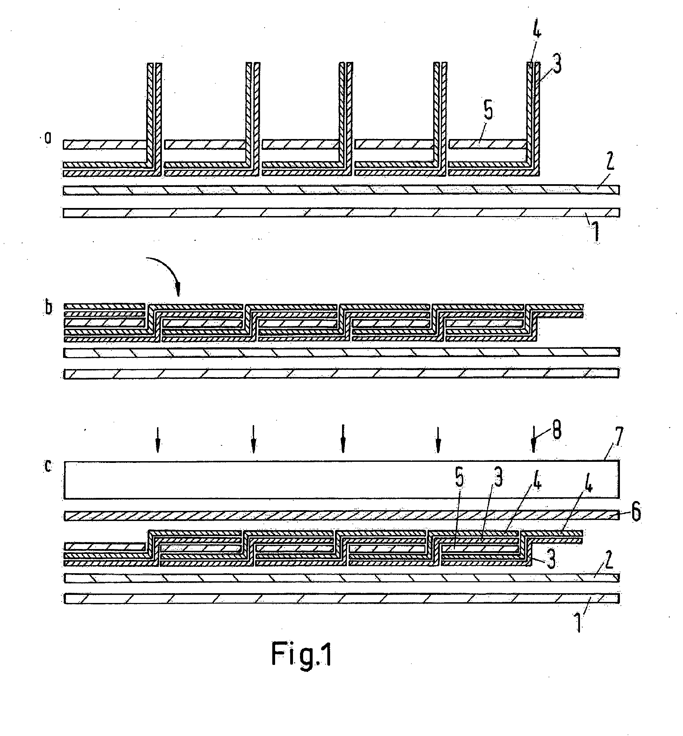

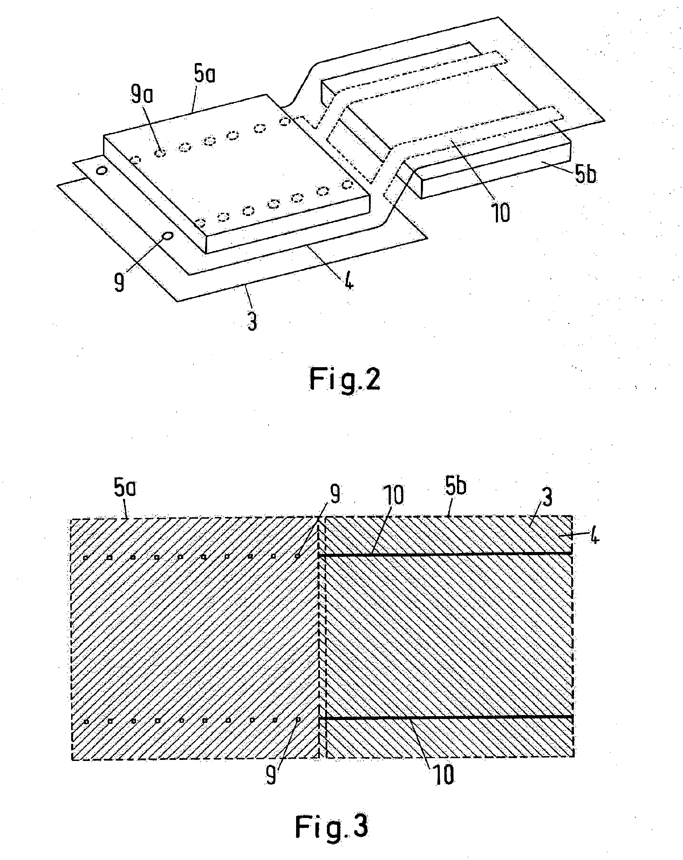

In Fig. 1 wird die Herstellung der erfindungsgemäßen Foliensystems in drei Schritten dargestellt. Zur weiteren Veranschaulichung ist zudem in Fig. 2 eine perspektivische Darstellung des erfindungsgemäßen Foliensystems zur Verschaltung von zwei Zellen dargestellt. Ein Foliensystem, bestehend aus Metallfolie (3) und Isolationsschicht (4) wird hergestellt. Dazu wird die Isolationsschicht (4) mit einem Verbindungsmittel oder mittels Extrusion auf die Metallfolie (3) aufgebracht. Die Folien werden passend auf die Größe der Menge an Zellen zugeschnitten, welche direkt von dieser Folie kontaktiert werden sollen. Die Folie wird so eingesetzt, dass die Metallfolie (3) unten und die Isolationsschicht (4) nach oben zeigt.

In dem Bereich einer Folie, auf welche eine PV-Zelle (5, 5a) mit ihrer Unterseite zu liegen kommt, werden beispielsweise mittels Laserverfahren kleine Öffnungen in die Isolationsschicht geschnitten, die Kontaktierungsöffnungen (9). Die Metallschicht (3) hingegen wird in dem Bereich, welcher auf einer Vorderseite einer benachbarten PV-Zelle (5b) zu liegen kommen soll, so abgetragen, beispielsweise mittels Laserverfahren oder einem Ätzvorgang, dass lediglich mindestens ein, bevorzugt zwei oder mehrere Anschlussfinger pro Zellenvorderseite übrig bleibt, je nachdem wie viele Kontaktlinien die Zelle aufweist. Die Isolationsschicht (4), die sich oberhalb der Anschlussfinger (10) befindet, wird dabei nicht beschädigt.

In dem Bereich der Folie, der mit den Kontaktierungsöffnungen (9) versehen ist, wird eine PV-Zelle (5a) auf die Isolationsschicht (4) gelegt und mittels Wärmebehandlung fixiert. Die PV-Zellen (5) sind mit einem Kontaktierungsmittel (Leitkleber oder Lot-Paste) versehen.

Eine so vorbereitete Folie wird auf die Modulrückseite, bestehend aus Modulabschluss (1) und Trägerfolie (2), gelegt (Fig. 1, Schritt a). Der Bereich der Folie, welcher mit den Anschlussfingern (10) versehen ist, wird nach oben geklappt damit eine weitere Folie, auf welcher ebenfalls im Bereich der Kontaktierungsöffnungen eine PV-Zelle fixiert ist, neben der ersten Folie zu liegen kommt (Fig. 1 und Fig. 2). Auf diese Weise kann eine ganze Reihe von PV-Zellen (hier fünf gezeigt) nebeneinander zu liegen kommen und miteinander verschaltet werden. Die Anzahl von PV-Zellen in einer Reihe ist dabei je nach gewünschter Größe des PV-Moduls variabel. Die PV-Zellen bilden die aktive Schicht (Leiterschicht) (5) des PV-Moduls.

Liegen alle Folien auf der Trägerfolie (2) des Modulabschlusses auf, werden die Bereiche der Folien mit den Anschlussfingern so umgeklappt, dass die Anschlussfinger (10) auf die zur Kontaktierung vorbereitete Vorderfläche der jeweiligen Nachbarzelle zu liegen kommen (Fig. 1, Schritt b). Die Anschlussfinger können mittels Wärmebehandlung fixiert werden.

Anschließend wird auf die Folienoberseite, der transparenten Isolationsschicht (2) eine Einbettschicht (6) und ein Frontglas (7) gelegt (Fig. 1, Schritt c). Im Laminator wird das PV-Modul verkapselt und die Kontaktierungen entstehen.

Fällt Licht (8) durch das Frontglas (7) des auf diese Art und Weise hergestellten PV-Moduls, fällt dieses durch die Einbettschicht (6) und die Isolationsschicht (4) auf die aktive Schicht (5). Unterhalb der PV-Zellen der aktiven Schicht (5) ist ebenfalls die Isolationsschicht (4) und darunter die Metallfolie (3) vorhanden. Die Metallfolie kann als Reflektor ausgestaltet ein, so dass Lichtstrahlen, welche durch die aktive Schicht gehen, von der Metallfolie (3) reflektiert werden und so weiter genutzt werden können.

Fig. 2 zeigt eine perspektivische Darstellung des erfindungsgemäßen Foliensystems zur Verschaltung von zwei PV-Zellen. Links ist eine PV-Zelle (5a) auf das Foliensystem aufgelegt, rechts befindet sich eine zweite PV-Zelle (5b) unter dem Foliensystem.

Es ist vorgesehen, dass sich eine erste PV-Zelle (5a) auf dem Bereich der Folie, bestehend aus Metallfolie (3) und Isolationsschicht (4) befindet, in welchem die Kontaktierungsöffnungen (9) zu der sich unter der Isolationsschicht (4) befindenden Metallfolie (3) befinden. Die Kontaktierungsöffnungen befinden sich dabei unter einer Kontaktlinie der Zellenunterseite. Zudem sind Kontaktierungsöffnungen (9a) schematisch als Ansicht durch eine PV-Zelle (5a) hindurch dargestellt. Der Bereich der Folie, in welchem aus der Metallschicht (3) die Anschlussfinger (10) geschnitten wurden, kommt auf den Kontaktlinien der Vorderseite der zweiten PV-Zelle (5b) zu liegen. Über den Anschlussfingern (10) ist die transparente Isolationsschicht (4) vorhanden.

Nicht dargestellt ist, dass die zweite PV-Zelle (5b) wiederum auf einer Folie bestehend aus Metallfolie (3) und Isolationsschicht (4), in dem Bereich mit den Kontaktierungsöffnungen (9) aufgebracht ist. Bevorzugt hat die Folie genau die Maße, wie zwei PV-Zellen plus deren Abstand. Überlappende Folien sind in dieser Figur allein aus Illustrationszwecken dargestellt.

Fig. 3 zeigt das erfindungsgemäße Foliensystem zur Verschaltung von zwei Zellen, wie in Fig. 2 dargestellt und beschrieben, in einer stark vereinfachten Darstellung, gesehen durch die transparente Isolationsschicht (4). Die gestrichelten Umrandungen symbolisieren die Lage der PV-Zellen; links (5a) auf das Foliensystem aufgelegt, rechts (5b) unter dem Foliensystem. Die Metallfolie (3) liegt unterhalb der transparenten Isolationsschicht (4). Die streifenförmigen Metallstrukturen stellen die beiden Anschlussfinger (10) dar. Die Anzahl der Anschlussfinger ist hier lediglich beispielhaft und nicht auf diese Anzahl begrenzt.

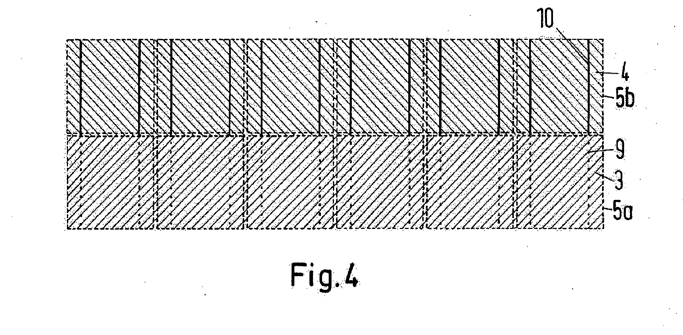

Alternativ kann ein Foliensystem auch alle Zellen einer Folge nebeneinander aufnehmen (z.B. sechs Reihen zu zehn Zellen für ein Modul mit 60 Zellen), wie im Fall der ersten zwei Reihen zu je einer Folge von sechs Zellen in der Fig. 4 dargestellt ist. Die Darstellungsform entspricht der Zeichnung in Fig.3, nur für eine Vielzahl von PV-Zellen. Es widerspricht nicht dem Gegenstand der vorliegenden Erfindung für eine ganze Folge von Zellen, dass auch andere Modulgrößen mit unterschiedlichen Zellenanzahlen mit umfasst sind. So sind neben dem bevorzugten Ausführungsbeispiel von sechs Zellen in zehn Reihen genauso zehn Zellen in sechs Reihen oder andere bevorzugte Zellen- und Reihenanzahlen möglich.

Dazu ist die Folie, bestehend aus Metallfolie (3) und Isolationsschicht (4), so abgemessen, dass sie in ihrer Breite mehrere PV-Zellen (5a, 5b, gestrichelt umrandet) nebeneinander (eine Folge von Zellen) aufnehmen kann. Das Foliensystem für eine ganze Folge von Zellen umfasst die Metallfolie und Isolationsschicht für bis zu 6 nebeneinander liegende Zellen mit den dafür notwendigen Leiterbahnstrukturen und Anschlussgeometrien - Kontaktöffnungen (9) für die Zellenunterseite und Anschlussfinger (10) für die Zellenvorderseite der Nachbarreihe. Jeweils bis zu zehn solcher, in Längsrichtung übereinander angeordnete Reihen zu je sechs Zellen ergeben ein PV-Modul. Vorzugsweise werden jeweils sechs Zellen, welche an den Kontaktierungsflächen mit einem Kontaktierungsmittel, vorzugsweise Leitkleber oder Lot-Paste, versehen sind, nebeneinander in Folge auf die Kontaktierungsflächen des Foliensystems aufgesetzt und mit einer Wärmebehandlung fixiert. Die Isolationsschicht ist an den jeweiligen Kontaktpunkten (9) geöffnet und für die Kontaktierung vorbereitet. Die Metallschicht ist in dem Bereich der Folie ohne Kontaktinseln so abgetragen worden, dass pro PV-Zelle mindestens ein Anschlussfinger (10), in diesem Fall jeweils zwei, vorhanden sind.

Die so mit den Foliensystemen zur Kontaktierung vorbereitete Zellenfolge wird auf die Modulrückseite, bestehend aus rückseitigem Modulabschluss (1) und Einbettfolie (2), aufgelegt, wobei die Anschlussfinger (10) auf die zur Kontaktierung vorbereitete Vorderflächen der jeweiligen Nachbarzellenfolge gelegt werden. Die Anschlussfinger können ebenfalls mittels Wärmebehandlung fixiert werden.

Eine zweite Folge von PV-Zellen wird wie in dem Fall zugefügt, dass nur eine Reihe von Zellen vorhanden ist. Der Bereich der Folie, bestehend aus Metallfolie und Isolationsschicht, der mit den Anschlussfingern versehen ist, wird nach oben geklappt. Eine zweite Folie, die ebenfalls wie die erste in dem Bereich mit den Kontaktöffnungen mit PV-Zellen versehen ist, kommt so neben der ersten Folie zu liegen, dass die Anschlussfinger der ersten Folie genau auf der Vorderseite der PV-Zellen zu liegen kommen, welche den Bereich mit den Kontaktierungsöffnungen der zweiten Folie bedecken.

Sind alle Reihen zurechtgelegt, in diesem Fall zehn, wie oben beschrieben, so wird das Modul mit der Einbettschicht, dem Frontglas und den Anschlüssen nach Außen versehen und im Laminator mittels Verkapselung und Kontaktierung fertiggestellt.

### Bezugszeichenliste

- 1.: Modulabschluss
- 2.: Trägerfolie
- 3.: Metallfolie
- 4.: Isolationsschicht
- 5.: aktive Schicht (Leiterschicht)
- 5a.: einzelne PV-Zelle
- 5b.: einzelne PV-Zelle
- 6.: Einbettschicht
- 7.: Frontglas
- 8.: Lichteinfall
- 9.: Kontaktierungsöffnung
- 9a.: Kontaktierungsöffnung (gesehen durch eine PV-Zelle)
- 10.: Anschlussfinger

## Patentansprüche

1. Foliensystem zur Kontaktierung von Photovoltaik-Zellen, bestehend aus:
- einer Metallfolie (3),
- einer Isolationsschicht (4), wobei
- die Isolationsschicht (4) auf die Metallfolie (3) aufgebracht ist, und
- mindestens zwei Photovoltaik-Zellen (5a, 5b)
**dadurch gekennzeichnet, dass**
- eine erste Photovoltaik-Zelle (5a) auf der Isolationsschicht (4) liegt, wobei
- die Isolationsschicht (4) unterhalb der ersten Photovoltaik-Zelle (5a) Kontaktierungsöffnungen aufweist, um eine elektrische Verbindung der Metallfolie (3), die sich unterhalb der Isolationsschicht (4) befindet, zu der Unterseite der ersten Photovoltaik-Zelle (5a) zu gewährleisten, welche auf der Isolationsschicht (4) liegt, und
- die Metallfolie (3) mindestens einen Anschlussfinger (10) auf einer benachbarten zweiten Photovoltaik-Zelle aufweist, bei dem die Kunststofffläche intakt ist, wobei
- der Anschlussfinger (10) der Metallfolie auf der Oberseite der benachbarten zweiten Photovoltaik-Zelle (5b) zu liegen kommt, und
- die Isolationsschicht (4), auf welcher die erste Photovoltaik-Zelle (5a) liegt, sich oberhalb des mindestens einen Anschlussfngers (10) auf der benachbarten zweiten Photovoltaik-Zelle (5b) erstreckt.

2. Foliensystem zur Kontaktierung von Photovoltaik-Zellen nach Anspruch 1,
**dadurch gekennzeichnet, dass**
- mehrere Photovoltaik-Zellen (5a, 5b) nebeneinander auf der Isolationsschicht (4) liegen, wobei
- die Isolationsschicht (4) unterhalb der ersten Reihe von Photovoltaik-Zellen (5a) Kontaktierungsöffnungen aufweist, um eine elektrische Verbindung der Metallfolie (3), die sich unterhalb der Isolationsschicht (4) befindet, zu der Unterseite der ersten Reihe von Photovoltaik-Zellen (5a) zu gewährleisten, welche auf der Isolationsschicht (4) liegen, und
- und die Metallschicht (3) mindestens einen Anschlussfinger (10) pro Photovoltaik-Zelle (5a, 5b) aufweist, wobei die Metallfolie (3) mindestens einen Anschlussfinger (10) auf einer benachbarten zweiten Photovoltaik-Zelle aufweist, bei dem die Kunststofffläche intakt ist, und
- die Anschlussfinger (10) der Metallfolie (3) jeweils auf der Oberseite der benachbarten zweiten Photovoltaik-Zelle (5b) zu liegen kommen, und
- die Isolationsschicht (4), auf welcher die erste Reihe von Photovoltaik-Zellen (5a) liegt, sich oberhalb der Anschlussfinger.(10) auf der benachbarten Reihe von Photovoltaik-Zellen (5b) erstreckt.

3. Foliensystem nach Anspruch 1 oder 2, **dadurch gekennzeichnet, dass** die Metallfolie (3)
- bevorzugt mittels Laserverfahren oder einem Ätzprozess so abgetragen wurde, dass mindestens ein Anschlussfinger entsteht, wobei die Kunststofffläche intakt bleibt; und/oder
- zwei oder drei leitende Anschlussfinger (10) zum Anschluss an die Zellenvorderseite aufweist; und/oder
- aus Kupfer und/oder Aluminium besteht; und/oder
- eine Dicke von mindestens 25 µm aufweist, vorzugsweise 25 µm bis 250 µm, besonders bevorzugt 50 µm bis 100 µm.

4. Foliensystem nach einem der vorherigen Ansprüche, **dadurch gekennzeichnet, dass** die Metallfolie (3)
- mit einer Beschichtung versehen ist, vorzugsweise aus reinem oder legiertem Kupfer oder Nickellegierungen; und/oder
- mit einer Schicht versehen ist, die die Reflexion erhöht, wobei es sich vorzugsweise um Siliziumdioxid und/oder Titandioxid handelt wobei die Schicht auf der Metallfolie (3) vorzugsweise eine Reflexion von > 80% im Wellenlängenbereich von 300 nm bis 1000 nm aufweist.

5. Foliensystem nach einem der vorherigen Ansprüche, **dadurch gekennzeichnet, dass** die Metallfolie (3)
- mit einer Oberflächentextur versehen ist, die vorzugsweise aus dreidimensionalen, regelmäßigen oder unregelmäßigen Strukturen, besonders bevorzugt aus Pyramiden oder Halbkugeln besteht, wobei die Textur vorzugsweise eine Höhe von 5 µm bis 10 µm, besonders bevorzugt eine zufällige Höhenverteilung von 5 µm bis 10 µm aufweist und/oder aus Pyramiden mit einem Scheitelwinkel von < 140° besteht; oder
- mit einer Oberflächentextur versehen ist, die vorzugsweise aus dreidimensionalen, regelmäßigen oder unregelmäßigen Strukturen, bevorzugt aus Pyramiden oder Halbkugeln besteht, wobei die Textur vorzugsweise eine Höhe von höchstens 1000 nm aufweist, wobei die Oberflächentextur und/oder die Pyramiden oder Halbkugeln besonders bevorzugt eine zufällige Höhenverteilung von 10-1000 nm, vorzugsweise 100-1000 nm aufweisen.

6. Foliensystem nach einem der vorherigen Ansprüche, **dadurch gekennzeichnet, dass** die Isolationsschicht (4)
- mit einem Verbindungsmittel versehen ist, wobei es sich bei dem Verbindungsmittel auf der Isolationsschicht (4) um einen Kleber handelt; und/oder die Isolationsschicht (4) haftend ausgestattet ist.

7. Foliensystem nach einem der vorherigen Ansprüche, **dadurch gekennzeichnet, dass** die Isolationsschicht (4)
- aus einem transparenten und elektrisch isolierenden Material, vorzugsweise einem Kunststoff oder einem Kunstharz, besonders bevorzugt einem Epoxid-Harz besteht, oder aus einer Sol-Gel-Schicht oder einer dielektrischen Schicht besteht.

8. Foliensystem nach einem der vorherigen Ansprüche, **dadurch gekennzeichnet, dass** die Isolationsschicht (4)
- aus einem Kunststoff besteht, der haftende Eigenschaften aufweist, vorzugsweise aus Polyvinylbutyral (PVB), und/oder aus Copolymeren, vorzugsweise EVA, und/oder silikonbasierten Kunststoffen und/oder thermoplastischen Kunststoffen, beispielsweise Ionomeren, besteht; und/oder
- im Bereich von 400 nm bis 1100 nm optisch transparent ist.

9. Verfahren zur Herstellung eines Foliensystems zur Kontaktierung von Photovoltaik-Zellen nach einem der Ansprüche 1 bis 8, umfassend folgende Schritte:
- Aufbringen einer Isolationsschicht (4) auf eine Metallfolie(3) durch eine haftende Verbindung, und
- Öffnen der Isolationsschicht (4) für Kontaktierung mit der Metallfolie (3),
- Abtragen der Metallfolie (3) in dem Bereich, welcher auf einer Vorderseite einer Photovoltaik-Zelle (5a, 5b) zu liegen kommt, mittels Laserverfahren oder einem Ätzprozess, so dass mindestens ein Anschlussfinger (10) entsteht,
- Aufbringen einer Photovoltaik-Zelle (5a) mit einem Verbindungsmittel auf die Isolationsschicht (4) und Fixierung der Photovoltaik-Zelle (5a) mittels Wärmebehandlung auf der Isolationsschicht (4),
- Umklappen des nicht von der Photovoltaik-Zelle (5a) besetzten Bereichs der Folie, bestehend aus Isolationsschicht (4) und Metallfolie (3), auf eine benachbarte Photovoltaik-Zelle (5b), so dass jede Photovoltaik-Zelle (5a, 5b) auf ihrer unteren Seite mit einer Isolationsschicht (4) und der darunter liegenden Metallfolie sowie auf ihrer Vorderseite mit mindestens einem Anschlussfinger (10) derselben Metallfolie und der darüber liegenden Isolationsschicht (4) verbunden ist.

10. Verfahren zur Herstellung eines Foliensystems zur Kontaktierung von Photovoltaik-Zellen nach einem der Ansprüche 1 bis 8, umfassend folgende Schritte:
- Aufbringen einer Isolationsschicht (4) auf eine Metallfolie (3) durch eine haftende Verbindung, und
- Öffnen der Isolationsschicht (4) für Kontaktierung mit der Metallfolie (3),
- Abtragen der Metallfolie (3) in dem Bereich, welcher auf einer Vorderseite einer Photovoltaik-Zelle (5a) zu liegen kommt, mittels Laserverfahren oder einem Ätzprozess, so dass mindestens ein Anschlussfinger (10) entsteht,
- Abmessen der Folie, bestehend aus Metallfolie (3) und Isolationsschicht (4), so dass sie in ihrer Breite mehrere PV-Zellen (5a, 5b) nebeneinander aufnehmen kann,
- Aufbringen mehrerer Photovoltaik-Zellen (5a, 5b) mit einem Verbindungsmittel auf die Isolationsschicht (4) und Fixierung der Photovoltaik-Zelle (5a) mittels Wärmebehandlung auf der Isolationsschicht (4),
- Umklappen des nicht von der Photovoltaik-Zelle (5a) besetzten Bereichs der Folie, bestehend aus Isolationsschicht (4) und Metallfolie (3), auf eine benachbarte Reihe von Photovoltaik-Zellen (5b), so dass jede Photovoltaik-Zelle (5a, 5b) auf ihrer unteren Seite mit einer Isolationsschicht (4) und der darunter liegenden Metallfolie (3) sowie auf ihrer Vorderseite mit mindestens einem Anschlussfinger (10) derselben Metallfolie und der darüber liegenden Isolationsschicht (4) verbunden ist.

11. Verfahren nach Anspruch 9 oder 10, **dadurch gekennzeichnet, dass**
- das Öffnen der Isolationsschicht (4) für die Kontaktierung mit der Metallfolie (3) in dem Bereich erfolgt, auf dem eine Unterseite einer Photovoltaik-Zelle (5a, 5b) zu liegen kommt; und/oder
- das Aufbringen einer Photovoltaik-Zelle (5a, 5b) mit einem Verbindungsmittel auf die Isolationsschicht (4) so erfolgt, dass die mindestens eine Kontaktlinie der Unterseite einer PV-Zelle (5a, 5b) auf den Kontaktierungsöffnungen (9) der Folie zu liegen kommt.

12. Verfahren nach einem der Ansprüche 9 bis 11, **dadurch gekennzeichnet, dass**
- eine Photovoltaik-Zelle (5a, 5b) an den Kontaktierungsflächen mit der Metallfolie (3) mit einem Kontaktierungsmittel versehen ist, vorzugsweise mit Leitkleber oder Lot-Paste; und/oder
- eine Photovoltaik-Zelle (5a, 5b) mit einer Wärmebehandlung auf der Folie, bestehend aus Isolationsschicht (4) und Metallfolie (3), fixiert wird.

13. Verfahren nach einem der Ansprüche 9 bis 12, **dadurch gekennzeichnet, dass**
- die mit dem Foliensystemen, bestehend aus Isolationsschicht (4) und Metallfolie (3), zur Kontaktierung vorbereiteten Photovoltaik-Zellen (5a, 5b) auf die Modulrückseite, bestehend aus rückseitigem Modulabschluss und Einbettfolie, gelegt werden, wobei die Anschlussfinger (10) auf die zur Kontaktierung vorbereitete mindestens eine Kontaktlinie der Zellenvorderseite Vorderfläche der jeweiligen Nachbarzelle gelegt und vorzugsweise mittels Wärmebehandlung fixiert werden; und/oder
- das Modul mit einer Einbettschicht (6) und einem Frontglas (7) versehen wird; und/oder
- mittels Laminationsprozess die Schichten miteinander verbunden werden.

14. Verfahren nach einem der Ansprüche 9 bis 13, **dadurch gekennzeichnet, dass**
- eine Reflektortextur in die Metallfolie (3) geprägt wird; oder
- die Isolationsschicht (4) auf der der Metallfolie (3) zugewandten Seite eine Reflektortextur aufweist, die bei dem Verbinden auf die Metallfolie übertragen wird.

15. Verfahren nach einem der Ansprüche 9 bis 14, **dadurch gekennzeichnet, dass**
- als Isolationsschicht (4) ein Kunstharz, vorzugsweise ein Epoxid-Harz eingesetzt wird, welches mittels Temperatur und/oder UV-Strahlung ausgehärtet wird; oder
- die Isolationsschicht (4) aus einer dielektrische Schicht besteht, welche mittels eines PVD-Verfahrens aufgebracht wird; und/oder
- zur Herstellung einer elektrischen Verbindung zwischen dem Verbundsystem und den Photovoltaik-Zellen (5a, 5b) ein thermisch aushärtender, elektrisch leitender Kleber oder tiefschmelzendes Lot auf den Kontaktierungsöffnungen (9) verwendet wird, oder über einen Laserlötprozess erfolgt.

## Claims

1. Foil laminate for contacting photovoltaic cells, comprising:
- a metal foil (3),
- an insulating layer (4), wherein
- the insulating layer (4) is applied to the metal foil (3), and
- at least two photovoltaic cells (5a, 5b)
**characterized in that**
- a first photovoltaic cell (5a) is located on the insulating layer (4), wherein
- the insulating layer (4) has contact openings under the first photovoltaic cell (5a) to provide an electrical connection between the metal foil (3), which lies below the insulating layer (4), and the lower surface of the first photovoltaic cell (5a), which lies on the insulating layer (4), and
- the metal foil (3) has at least one connection finger (10) on an adjacent second photovoltaic cell, wherein the plastic surface is intact, wherein
- the connection finger (10) of the metal foil lies on the upper side of the adjacent second photovoltaic cell (5b), and
- the insulating layer (4) on which the first photovoltaic cell (5a) is located, extends above the at least one connecting finger (10) on the adjacent second photovoltaic cell (5b).

2. Foil laminate for contacting photovoltaic cells according to claim 1, **characterized in that**
- a plurality of photovoltaic cells (5a, 5b) are juxtaposed on the insulating layer (4), wherein
- the insulating layer (4) has contact openings under the first row of photovoltaic cells (5a) to provide an electrical connection between the metal foil (3), which lies below the insulating layer (4), and the lower surface of the first row of photovoltaic cells (5a), which lie on the insulating layer (4), and
- the metal foil (3) has at least one connection finger (10) per photovoltaic cell (5a, 5b), wherein the metal foil (3) has at least one connection finger (10) on an adjacent second photovoltaic cell, wherein the plastic surface is intact, and
- the connection fingers (10) of the metal foil (3) each are located on the respective adjacent upper surface of the second photovoltaic cell (5b) and
- the insulating layer (4) on which the first row of photovoltaic cells (5a) is located, extends above the connection fingers (10) on the adjacent row of photovoltaic cells (5b).

3. Foil laminate according to claim 1 or 2, **characterized in that** the metal foil (3)
- is preferentially removed by a laser method or an etching process so that at least one connection finger is built, whereas the plastic surface remains intact; and / or
- comprises two or three conductive connection fingers (10) for connection to the front side of the photovoltaic cell; and / or
- consists of copper and / or aluminum; and / or
- has a thickness of at least 25 µm, preferably 25 µm to 250 µm, more preferably 50 µm to 100 µm.

4. Foil laminate according to one of the preceding claims, **characterized in that** the metal foil (3)
- comprises a coating, preferably made of pure or alloyed copper or nickel alloys; and / or
- comprises a layer that increases the reflection, which is preferably silicon dioxide and / or titanium dioxide, wherein the layer on the metal foil (3) preferably has a reflectivity of > 80% in the wavelength range from 300 nm to 1000 nm.

5. Foil laminate according to one of the preceding claims, **characterized in that** the metal foil (3)
- comprises a surface texture that preferably consists of three-dimensional, regular or irregular structures, more preferably of pyramids or hemispheres, whereas the texture preferably has a height of 5 µm to 10 µm, more preferably a random height distribution of 5 µm to 10 µm and / or consists of pyramids with an vertical angle of <140 °; or
- comprises a surface texture, preferably consisting of three-dimensional, regular or irregular structures, preferably pyramids or hemispheres, wherein the texture preferably has a height of not more than 1000 nm, wherein the surface texture and / or the pyramids or hemispheres more preferably have a random height distribution of 10-1000 nm, preferably 100-1000 nm.

6. Foil laminate according to any one of the preceding claims, **characterized in that** the insulating layer (4)
- comprises a connecting means, wherein the connecting means on the insulating layer (4) is an adhesive; and / or the insulating layer (4) is adhesive.

7. Foil laminate according to any one of the preceding claims, **characterized in that** the insulating layer (4)
- consists of a transparent and electrically insulating material, preferably a plastic material or resin, more preferably an epoxy resin, or a sol-gel layer or a dielectric layer.

8. Foil laminate according to any one of the preceding claims, **characterized in that** the insulating layer (4)
- consists of a plastic material with adhesive properties, preferably polyvinyl butyral (PVB), and / or copolymers, preferably EVA and / or silicone-based plastic materials and / or thermoplastic materials, such as ionomers; and / or
- is optically transparent in the range of 400 nm to 1100 nm.

9. A method for production of a foil laminate for contacting photovoltaic cells according to any of the claims 1 to 8, comprising the steps of:
- applying an insulating layer (4) on a metal foil (3) by an adhesive bond, and
- opening of the insulating layer (4) for contacting the metal foil (3),
- removing the metal foil (3) at the area which lies on a front side of a photovoltaic cell (5a, 5b) by laser method or an etching process, so that at least one connection finger (10) is formed,
- applying one photovoltaic cell (5a) with a connecting means on the insulating layer (4) and fixing of the photovoltaic cell (5a) by means of heat treatment on the insulating layer (4),
- folding back the area of the foil laminate, consisting of the insulating layer (4) and the metal foil (3), which is not covered by a photovoltaic cell (5a) on an adjacent photovoltaic cell (5b) so that each photovoltaic cell (5a, 5b) is connected on its lower side to an insulating layer (4) and the underlying metal foil and is connected on its front side with at least one connection finger (10) of the same metal foil to the overlying insulating layer (4).

10. A method for production of a foil laminate for contacting photovoltaic cells according to any of the claims 1 to 8, comprising the steps of:
- applying an insulating layer (4) on a metal foil (3) by an adhesive bond, and
- opening of the insulating layer (4) for contacting the metal foil (3),
- removing the metal foil (3) at the area which lies on a front side of a photovoltaic cell (5a, 5b) by laser method or an etching process, so that at least one connection finger (10) is formed,
- measuring the film, consisting of metal foil (3) and insulating layer (4) so that several PV cells (5a, 5b) can be applied breadthways side by side,
- applying several photovoltaic cells (5a, 5b) with a connection means on the insulating layer (4) and fixing of the photovoltaic cell (5a) by means of heat treatment on the insulating layer (4),
- folding back the area of the foil laminate, consisting of the insulating layer (4) and the metal foil (3), which is not covered by a photovoltaic cell (5a) on an adjacent row of photovoltaic cells (5b) so that each photovoltaic cell (5a, 5b) is connected on its lower side to an insulating layer (4) and the underlying metal foil and is connected on its front side with at least one connection finger (10) of the same metal foil to the overlying insulating layer (4).

11. The method according to claim 9 or 10, **characterized in that**
- the opening of the insulating layer (4) for contacting the metal foil (3) is located in the region on which a lower side of a photovoltaic cell (5a, 5b) is placed; and / or
- the photovoltaic cell (5a, 5b) is applied with a connecting means on the insulating layer (4) in such way that the at least one contacting line of the lower side of a PV cell (5a, 5b) is located on the contact openings (9) of the film.

12. The method according to any one of claims 9 to 11, **characterized in that**
- a photovoltaic cell (5a, 5b) comprises a contact means at the contact surfaces to the metal foil (3), preferably being conductive glue or solder paste; and / or
- a photovoltaic cell (5a, 5b) is fixed with a heat treatment on the foil laminate consisting of insulating layer (4) and metal foil (3).

13. The method according to any one of claims 9 to 12, **characterized in that**
- the photovoltaic cells (5a, 5b) with the foil laminate consisting of insulating layer (4) and metal foil (3) prepared for contacting, are placed on the back side of the module, consisting of the module closure and an embedding film, wherein the connection finger (10) is placed on the at least one contacting line of the cell front side of the respective adjacent cell and fixed preferably by heat treatment; and / or
- the module comprises an embedded layer (6) and a front glass (7); and / or
- the layers are connected by means of lamination.

14. The method according to any one of claims 9 to 13, **characterized in that**
- a reflector texture is embossed into the metal foil (3); or
- the insulating layer (4) comprises a reflector texture on the side which faces the metal foil (3), which is transferred to the metal foil during the connection.

15. The method according to any one of claims 9 to 14, **characterized in that**
- a synthetic resin, preferably an epoxy resin is used as insulating layer (4) which is cured by means of temperature and / or UV radiation; or
- the insulating layer (4) consists of a dielectric layer, which is applied by means of a PVD process; and / or
- for making an electrical connection between the foil laminate and the photovoltaic cells (5a, 5b) a thermally curing, electrically conductive adhesive or low melting solder is used on the contact openings (9), or is achieved by laser soldering.

## Revendications

1. Système de feuilles pour contacter des cellules photovoltaïques, comprenant:
- une feuille métallique (3),
- une couche isolante (4), dans lequel
- la couche isolante (4) est appliquée sur la feuille métallique (3), et
- au moins deux cellules photovoltaïques (5a, 5b)
**caractérisé en ce que**
- une première cellule photovoltaïque (5a) est posé sur la couche isolante (4), dans lequel
- la couche isolante (4) comporte en dessous de la première cellule photovoltaïque (5a) des ouvertures de contact qui assurent une connexion électrique entre la feuille métallique (3), qui se trouve au-dessous de la couche isolante (4), et la face inférieure de la première cellule photovoltaïque (5a) qui se trouve sur la couche isolante (4), et
- la feuille métallique (3) comporte au moins un doigt de connexion (10) sur une deuxième cellule photovoltaïque adjacente, dans lequel la surface de matière plastique est intacte, dans lequel
- les doigts de connexion (10) de la feuille métallique sont placé sur la surface supérieure de la seconde cellule photovoltaïque adjacente (5b), et
- la couche isolante (4) sur laquelle la première cellule photovoltaïque (5a) est placé s'étend au-dessus du au moins un doigt de connexion (10) sur la seconde cellule photovoltaïque adjacente (5b).

2. Système de feuilles pour contacter des cellules photovoltaïques selon la revendication 1, **caractérisé en ce que**
- une pluralité de cellules photovoltaïques (5a, 5b) sont juxtaposés sur la couche isolante (4), dans lequel
- la couche isolante (4) en dessous de la première rangée de cellules photo-voltaïques (5a) comporte des ouvertures de contact pour assurer une connexion électrique entre la feuille métallique (3), qui se trouve en dessous de la couche isolante (4) avec le dessous de la première rangée de cellules photovoltaïques (5a), et
- la feuille métallique (3) comporte au moins un doigt de connexion (10) par cellule photovoltaïque (5a, 5b), dans lequel la feuille métallique (3) comporte au moins un doigt de connexion (10) sur une deuxième cellule photovoltaïque adjacent, dans lequel la surface en plastique est intacte, et
- les doigts de connexion (10) de la feuille métallique (3) se trouvent chacun sur la surface supérieure adjacente de la seconde cellule photovoltaïque (5b), et
- la couche isolante (4) sur laquelle se trouve la première rangée de cellules photovoltaïques (5a), s'étend au-dessus des doigts de connexion (10) sur la rangée de cellules photovoltaïques adjacente (5b).

3. Système de feuilles selon la revendication 1 ou 2, **caractérisé en ce que** la feuille métallique (3)
- est de préférence éliminé par un traitement laser ou un procédé de gravure de telle sorte qu'au moins un doigt de connexion est formée, pendant que la surface en plastique reste intacte; et / ou
- comporte deux ou trois doigts conducteurs de connexion (10) pour la connexion avec la face frontale de la cellule; et / ou
- consiste en cuivre et / ou aluminium; et / ou
- a une épaisseur d'au moins 25 µm, préférable de 25 µm à 250 µm, particulièrement préférable de 50 µm à 100 µm.

4. Système de feuilles selon l'une des revendications précédentes, **caractérisé en ce que** la feuille métallique (3)
- comporte un revêtement, de préférence en cuivre pur ou allié ou en alliages de nickel; et / ou
- comporte une couche qui augmente la réflexion, qui est de préférence du dioxyde de silicium et / ou du dioxyde de titane, dans laquelle la couche sur la feuille de métal (3) de préférence a une réflexion de > 80% dans la plage de longueurs d'onde de 300 nm à 1000 nm.

5. Système de feuilles selon l'une des revendications précédentes, **caractérisé en ce que** la feuille métallique (3)
- comporte une texture de surface, qui de préférence se compose de structures tridimensionnelles réguliers ou irréguliers, plus préférablement de pyramides ou hémisphères, avec une texture de préférence à une hauteur de 5 µm à 10 µm, plus préférablement une distribution de hauteur aléatoire de 5 µm à 10 µm et / ou comporte des pyramides ayant un angle au sommet de <140 °; ou
- comporte une texture de surface, qui de préférence se compose de structures tridimensionnelles réguliers ou irréguliers, plus préférablement de pyramides ou hémisphères, dans lequel la texture a de préférence une hauteur d'au plus 1000 nm, dans lequel la texture de surface et / ou les pyramides ou hémisphères plus préférablement ont une distribution en hauteur aléatoire de 10 à 1000 nm, de préférence 100-1000 nm.

6. Système de feuilles selon l'une quelconque des revendications précédentes, **caractérisé en ce que** la couche isolante (4)
- comporte un moyen de liaison, dans lequel le moyen de liaison sur la couche isolante (4) est un adhésif; et / ou la couche isolante (4) est adhésive.

7. Système de feuilles selon l'une quelconque des revendications précédentes, **caractérisé en ce que** la couche isolante (4)
- est constituée d'un matériau transparent et électriquement isolant, de préférence une matière plastique ou une résine synthétique, plus préférablement une résine époxy ou une couche sol-gel ou une couche diélectrique.

8. Système de feuilles selon l'une quelconque des revendications précédentes, **caractérisé en ce que** la couche isolante (4)
- consiste d'une matière plastique avec des propriétés d'adhérence, de préférence en polyvinylbutyral (PVB), et / ou des copolymères, de préférence EVA et / ou des matières plastiques à base de silicone et / ou des matières thermoplastiques, tels que des ionomères; et / ou
- est optiquement transparent entre 400 nm et 1100 nm.

9. Procédé de production d'un système de feuilles pour contacter des cellules photovoltaïques selon l'une des revendications 1 à 8, comprenant les étapes suivantes:
- déposer d'une couche isolante (4) sur une feuille métallique (3) par une liaison adhésive, et
- ouvrir la couche isolante (4) pour contacter le film métallique (3),
- éliminer la feuille métallique (3) dans la région qui se trouve sur une face frontale d'une cellule photovoltaïque (5a, 5b), de sorte qu'au moins un doigt de connexion (10) est formée par un procédé laser ou un procédé de gravure,
- appliquer une cellule photovoltaïque (5a), avec un moyen de connexion sur la couche isolante (4) et fixer la cellule photovoltaïque (5a) au moyen d'un traitement thermique sur la couche isolante (4)
- rabattre la partie non-occupée de cellules photovoltaïques (5a) du film composé de couche isolante (4) et feuille métallique (3) sur une cellule photovoltaïque adjacente (5b) de sorte que chaque cellule photovoltaïque (5a, 5b) est reliée sur son côté inférieur à une couche d'isolation (4) et la feuille métallique sous-jacent et sur le côté supérieur à au moins un doigt de connexion (10) de la même couche métallique et de la couche isolante (4) sus-jacente.

10. Procédé de production d'un système de feuilles pour contacter des cellules photovoltaïques selon l'une des revendications 1 à 8, comprenant les étapes suivantes:
- déposer d'une couche isolante (4) sur une feuille métallique (3) par une liaison adhésive, et
- ouvrir la couche isolante (4) pour contacter le film métallique (3),
- éliminer la feuille métallique (3) dans la région qui se trouve sur une face frontale d'une cellule photovoltaïque (5a, 5b), de sorte qu'au moins un doigt de connexion (10) est formée par un procédé laser ou un procédé de gravure,
- mesure le film, constitué d'une feuille métallique (3) et d'une couche isolante (4) de sorte que plusieurs cellules photovoltaïques (5a, 5b) peuvent être placer côte à côte en largeur,
- appliquer plusieurs cellules photovoltaïques (5a), avec un moyen de connexion sur la couche isolante (4) et fixer la cellule photovoltaïque (5a) au moyen d'un traitement thermique sur la couche isolante (4)
- rabattre la partie non-occupée de cellules photovoltaïques (5a) du film composé de couche isolante (4) et feuille métallique (3) sur une rangée de cellule photovoltaïque adjacente (5b) de sorte que chaque cellule photovoltaïque (5a, 5b) est reliée sur son côté inférieur à une couche d'isolation (4) et la feuille métallique sous-jacent et sur le côté supérieur à au moins un doigt de connexion (10) de la même couche métallique et de la couche isolante (4) sus-jacente.

11. Procédé selon la revendication 9 ou 10, **caractérisé en ce que**
- l'ouverture de la couche isolante (4) pour établir un contact avec la feuille métallique (3) se trouve dans la région sur laquelle une face inférieure d'une cellule photovoltaïque (5a, 5b) se trouve; et / ou
- l'application d'une cellule photovoltaïque (5a, 5b) avec un moyen de connexion sur la couche isolante (4) est réalisée de telle sorte que la ligne de contact sur la face inférieure d'une cellule photovoltaïque (5a, 5b) se trouve sur les ouvertures de contact (9) du film.

12. Procédé selon l'une quelconque des revendications 9 à 11, **caractérisé en ce que**
- une cellule photovoltaïque (5a, 5b) comprend un moyen de contact pour contacter la feuille métallique (3), de préférence une colle conductrice ou une pâte à souder; et / ou
- une cellule photovoltaïque (5a, 5b) est fixé par un traitement thermique sur le film, comprenant une couche isolante (4) et une feuille métallique (3).

13. Procédé selon l'une quelconque des revendications 9 à 12, **caractérisé en ce que**
- les cellules photovoltaïques (5a, 5b) préparées avec un système de feuilles, comprenant une couche isolante (4) et une feuille métallique (3) sont posé sur l'arrière d'un panneau, comprenant le dos du module et une couche d'encastrement, de sorte que les doigts de connexion (10) sont posé sur la ligne de contact sur la face frontale de la cellule adjacente respective et sont fixé de préférence par un traitement thermique; et / ou
- le module comporte une couche d'encastrement (6) et un verre avant (7); et / ou
- les couches sont liées par un processus de laminage.

14. Procédé selon l'une quelconque des revendications 9 à 13, **caractérisé en ce que**
- une texture réflecteur est estampé dans la feuille métallique (3); ou
- la couche isolante (4) comporte une texture réflecteur sur le cote face au film métallique (3), qui est transférée sur la feuille métallique lors de la connexion avec la feuille métallique.

15. Procédé selon l'une quelconque des revendications 9 à 14, **caractérisé en ce que**
- la couche isolante (4) est fait d'une résine synthétique, de préférence une résine époxy, qui est durci par une température et / ou par rayonnement UV; ou
- la couche isolante (4) est constituée d'une couche diélectrique, qui est appliqué par un procédé PVD; et / ou
- pour établir une connexion électrique entre le système de feuilles et les cellules photovoltaïques (5a, 5b) un adhésif thermodurcissable et électriquement conducteur ou une soudure à bas point de fusion est appliquer sur les ouvertures de contact (9), ou une soudure au laser est utiliser.
